# EUROPÄISCHE PATENTANMELDUNG

(11) **EP 1 119 047 A1**
(43) Veröffentlichungstag der Anmeldung: **25.07.2001**
(21) Anmeldenummer: 00100953.9
(22) Anmeldetag: 18.01.2000
(51) Int. Cl.: H01L 23/498, G06K 19/077

(54) **Flächiger Träger für ein Chipmodul und Herstellungsverfahren für ein Chipmodul**

(71) Anmelder: Infineon Technologies AG, 81669 München (DE)
(72) Erfinder: Püschner, Frank, 93309 Kehlheim (DE); Heinemann, Erik, 93049 Regensburg (DE); Houdeau, Detlef, Dr., 84085 Langquaid (DE)
(74) Vertreter: Fischer, Volker, Dipl.-Ing.

(57) **Zusammenfassung**

Die Erfindung schlägt einen flächigen Träger, insbesondere für ein Chipmodul für den Einsatz in Chipkarten, mit einer ersten und einer zweiten Hauptseite vor, bei dem auf der ersten Hauptseite eine Vielzahl an ersten Metallisierungen und auf der zweiten Hauptseite eine entsprechende Anzahl an zweiten Metallisierungen vorgesehen ist. Die lateralen Ausnehmungen des flächigen Trägers sind derart bemessen, daß der flächige Träger von einem SMD-Bestückungsautomaten weiter verarbeitet werden kann. Hierdurch ist die Verwendung von günstigen Materialien und gängigen Arbeitsverfahren möglich. Andererseits kann mit einem SMD-Bestückungsautomaten ein sehr hoher Durchsatz erzielt werden.

## Beschreibung

Die Erfindung betrifft einen flächigen Träger, insbesondere für ein Chipmodul für den Einsatz in Chipkarten, mit einer ersten und einer zweiten Hauptseite, bei dem auf der ersten Hauptseite eine Vielzahl an ersten Metallisierungen und auf der zweiten Hauptseite eine entsprechende Anzahl an zweiten Metallisierungen vorgesehen ist.

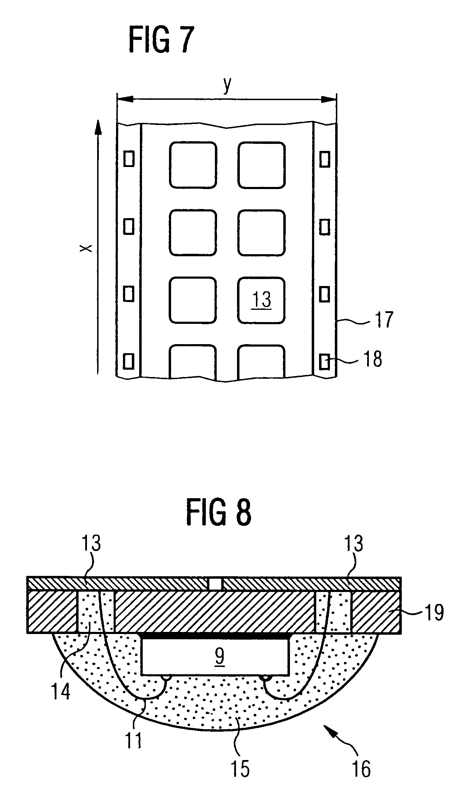

Ein aus dem Stand der Technik bekanntes und regelmäßig eingesetztes Chipmodul für Chipkarten ist in der Figur 8 dargestellt. Das Chipmodul 16 weist einen Träger 19 auf, der üblicherweise aus Epoxydharz besteht. Auf einer ersten Hauptseite des Trägers 19 ist ein Halbleiterchip 9 aufgebracht, der beispielsweise mittels Kleben mit dem Träger 19 verbunden ist. Auf einer der ersten Hauptseite gegenüberliegenden zweiten Hauptseite des Trägers 19 ist eine Metallisierung 13 aufgebracht. Die Metallisierung 13 bildet die später von außen zugänglichen Kontakte des Chipmoduls 16. Die Metallisierung 13, die üblicherweise aus sechs oder acht voneinander elektrisch getrennten Kontaktflächen besteht, ist über Bonddrähte 11 mit Kontaktpads des Halbleiterchips 9 verbunden. Die Bonddrähte 11 sind dabei durch Ausnehmungen 14 in dem Träger 19 hindurch geführt. Für einen mechanischen Schutz des Halbleiterchips 9 und der Bonddrähte 11 ist auf der ersten Hauptseite eine Vergußmasse 15 aufgebracht, die den Halbleiterchip 9 und die Bonddrähte 11 umgibt.

Das in der Figur 8 gezeigte Chipmodul 16 wird in einem sog. "Reel-to-Reel"-Verfahren hergestellt. Bei diesem Verfahren wird ein Clip-Trägerband aus Epoxydharz bereitgestellt, das zwischen zwei Rollen als Endlosband läuft. Das Trägerband 17 ist dabei in der Regel nach dem JEDEC-Standard ausgebildet. Dies bedeutet, das Trägerband weist eine Breite von etwa 35 mm auf. Ein Ausschnitt aus einem derartigen Trägerband ist in der Figur 7 dargestellt. Das Trägerband 17 weist entlang seiner Ränder Führungslöcher 18 auf, mit denen das Trägerband 17 transportiert werden kann. In einem ersten Herstellprozess wird das Trägerband 17 mit den Ausnehmungen 14, z.B. durch Stanzen, versehen. Anschließend wird auf die zweite Hauptseite die Metallisierung 13, z.B. eine Kupferkaschierung, aufgebracht und anschließend photolithographisch strukturiert sowie oberflächenveredelt (Ni An). Die Breite y (35 mm) erlaubt es, zwei Metallisierungen 13 bzw. spätere Module nebeneinander und beabstandet auf dem Trägerband 17 vorzusehen. In den nächsten sogenannten Modulmontage-Verfahrensschritten werden auf der ersten Hauptseite die Halbleiterchips 9 aufgebracht. Anschließend werden die Kontaktpads der Halbleiterchips mit der Metallisierung 13 durch die Ausnehmungen hindurch miteinander verbunden. Abschließend erfolgt das Umgießen mit einer Vergußmasse. Schließlich werden die fertiggestellten Chipmodule 16, z.B. durch Sägen oder Stanzen, vereinzelt.

Die eben beschriebenen Verfahrensschritte werden an verschiedenen Bearbeitungsstationen ausgeführt. Die Bearbeitungsstationen befinden sich dabei entlang der x-Achse des Trägerbandes 17. Das Trägerband 17 wird entlang der x-Richtung an den einzelnen Bearbeitungsstationen vorbei geführt, wobei diese parallel arbeiten können.

Bei einem einseitig metallisierten Träger muß die Verbindung zwischen dem Halbleiter und der Metallisierung mittels Bonddrähten vorgenommen werden. Da der Verfahrensschritt des Bondens Temperaturen von > 150° Celsius mit sich bringt, ist es notwendig, das Material des Trägers temperaturbeständig bezüglich dieses Verfahrensschrittes auszuführen. Die dadurch bedingte Verwendung von Epoxydharz, das die geforderten Eigenschaften erfüllt, wirkt sich jedoch preistreibend auf die Stückkosten eines Chipmodules aus.

Mit dem bekannten Herstellungsverfahren ist es auch möglich, einen Träger, der beidseitig metallisiert und durchkontaktiert ist, herzustellen. Ein derartiges Chipmodul zum Einsatz in einer Chipkarte ist beispielsweise aus der EP 0 071 311 A2 bekannt. In der Figur 2 dieser Druckschrift ist ein integrierter Baustein über seine Kontaktelemente mit den Anschlußstellen von Leiterbahnen verbunden, die auf einer flexiblen Kunststoff-Folie aufgebracht sind. Die Kunststoff-Folie ist dabei beidseitig kupferkaschiert, durchmetallisiert und mit entsprechenden Kontakten auf der zweiten Hauptseite der Kunststoff-Folie zur Außenwelt versehen. Zur Erhöhung der Festigkeit des integrierten Bausteins auf der Kunststoffolie ist dieser von einer isolierenden und aushärtenden Kunststoff- bzw. Vergußmasse umhüllt.

Ein zweiseitig metallisierter Träger wird in der Praxis selten verwendet, da dieser bei einer Herstellung mit dem beschriebenen JEDEC-Standard gegenüber einem einseitig metallisierten Träger unverhältnismäßig teuer ist.

Die Aufgabe der vorliegenden Erfindung besteht nunmehr darin, ein Herstellungsverfahren für ein Chipmodul, das für den Einsatz in einer Chipkarte gedacht ist, bereit zu stellen, das die bei den bekannten Herstellungsverfahren aus dem Stand der Technik genannten Nachteile nicht aufweist.

Diese Aufgabe wird durch die Merkmale des Patentanspruches 1 gelöst. Erfindungsgemäß wird das Herstellungsverfahren von der Ausgestaltung des flächigen Trägers geprägt, der eine erste und eine zweite Hauptseite aufweist, bei dem auf der ersten Hauptseite eine Vielzahl an ersten Metallisierungen und auf der zweiten Hauptseite eine entsprechende Anzahl an zweiten Metallisierungen vorgesehen ist, wobei die lateralen Ausdehnungen des flächigen Trägers derart bemessen sind, daß der flächige Träger von einem SMD-Bestückungsautomaten weiter bearbeitet werden kann.

Im Gegensatz zum Stand der Technik werden die Metallisierungen nicht auf einem Trägerband gemäß dem JEDEC-Standard aufgebracht, sondern auf einem flächigen Träger, der eine an SMD-Bestückungsautomaten angepaßte Größe aufweist. Hierdurch können die Kosten zur Herstellung eines Chipmoduls wesentlich reduziert werden, da mittels eines Standard-SMD-Bestückungsautomaten eine wesentlich höhere Anzahl an Chipmodulen gefertigt werden kann. Bei einem Reel-to-Reel-Verfahren können derzeit ca. 6000 Chipmodule hergestellt werden. Ein SMD-Bestückungsautomat ist hingegen in der Lage, ca. 50.000 Chipmodule pro Stunde zu fertigen. Dies ist dadurch bedingt, daß dieser verfahrensbedingt einen wesentlich höheren Durchsatz ermöglicht. Weiterhin können die Herstellungskosten für ein Chipmodul dadurch gesenkt werden, daß die in einer Fertigungsstätte benötigten räumlichen Dimensionen für einen SMD-Bestückungsautomaten wesentlich geringer sind, als wenn mittels einer herkömmlichen Reel-to-Reel-Verarbeitungslinie der gleiche Durchsatz erzielt werden wollte. Der flächige Träger ermöglicht es nunmehr in vorteilhafter Weise, daß nicht nur zwei Metallisierungen nebeneinander auf dem Träger angeordnet werden können, sondern je nach den Abmaßen des flächigen Trägers eine wesentlich höhere Anzahl an Metallisierungen nebeneinander angeordnet werden kann.

Vorteilhafterweise besteht der flächige Träger aus einem thermoplastischen Kunststoff oder Papier. Dadurch, daß der flächige Träger beidseitig metallisiert ist, wird die elektrische Verbindung zwischen dem Halbleiterchip und der ersten Metallisierung nicht mehr mittels Bonddrähten, sondern beispielsweise über eine Flipchip-Kontaktierung hergestellt. Hierbei treten wesentlich geringere Verarbeitungstemperaturen auf. Somit ist es möglich, als Trägermaterial ein kostengünstigeres Material einzusetzen. Hierdurch können die Herstellungskosten des Chipmoduls verringert werden. Zudem ermöglicht es eine Flipchip-Kontaktierung in vorteilhafter Weise, die Bauhöhe des Chipmoduls zu verringern. Es kann sich hierbei zudem der Schritt des Umgießens des Halbleiterchips mit einer Vergußmasse gespart werden, da die elektrische Verbindung zwischen dem Halbleiterchip und der ersten Metallisierung mechanisch nicht beschädigt werden kann.

Als Kunststoff können z.B. ABS, PET, PVC oder PC verwendet werden. Die Verwendung eines thermoplastischen Kunststoffs bringt weiterhin den Vorteil mit sich, daß die Verbindung des Chipmoduls mit einer Chipkarte besonders einfach ist. Dies liegt daran, daß auch die Chipkarte aus einem thermoplastischen Kunststoff besteht und somit die Verbindung zwischen dem Modul und der Chipkarte beispielsweise durch Heiß/Kaltkleben, Schweißen oder eine Ultraschallverbindung hergestellt werden kann. Ein thermoplastischer Kunststoff weist weiterhin den Vorteil auf, daß dieser elektrisch isolierend ist. Auf diese Weise kann ein Kurzschluß zwischen der ersten und der zweiten Metallisierung vermieden werden.

Vorteilhafterweise sind einander zugeordnete erste und zweite Metallisierungen über Durchkontaktierungen in dem flächigen Träger miteinander elektrisch verbunden. Die zweiseitige Metallisierung des Trägers entspricht somit einer Umverdrahtung. Dies ermöglicht eine besonders einfache Herstellung eines Chipmoduls.

Die zweiten Metallisierungen weisen vorteilhafterweise zweite Kontaktflächen auf, die für eine externe Kontaktierung vorgesehen sind. Die zweite Metallisierung wird dabei vorteilhafterweise nach einem ISO-Standard ausgebildet. Eine Metallisierung kann dann acht oder sechs Kontaktflächen aufweisen.

Die ersten Metallisierungen weisen vorteilhafterweise erste Kontaktflächen auf, die derart angeordnet sind, daß diese beim Aufbringen eines Halbleiterchips auf die erste Hauptseite des flächigen Trägers mit Kontaktflächen des Halbleiterchips aufeinander treffen. Hierdurch ist keine zusätzliche Umverdrahtung notwendig. Der Träger übernimmt die Aufgabe der Umverdrahtung. Vor dem Aufeinanderbringen des Halbleiterchips mit den ersten Kontaktflächen werden die Kontaktflächen des Halbleiterchips vorteilhafterweise mit einer Nickel-Gold-Legierung versehen. Dadurch wird zum einen die Verbindung mit der ersten Kontaktfläche verbessert, zum anderen wird eine Korrosion dieser elektrischen Verbindung verhindert. Die ersten Kontaktflächen der ersten Metallisierung können beliebig gestaltet sein. Vorteilhafterweise werden sie besonders groß ausgeführt, so daß die Verbindung mit den Kontaktflächen des Halbleiterchips einfach vorzunehmen ist.

Alternativ kann die zweite Metallisierung zweite Kontaktflächen aufweisen, die zur Verbindung mit einer Spule zur kontaktlosen Datenübertragung vorgesehen sind. Die Spule kann dabei auf einem zweiten, flächigen Träger vorgesehen sein. Die Erfindung ermöglicht es, auch weit auseinander liegende Spulenenden mit dem Halbleiterchip zu verbinden, wobei eine zweiseitige Metallisierung mit einer Durchkontaktierung nicht auf dem flächigen Träger, auf dem die Spule aufgebracht ist, vorgenommen werden muß. Die Durchkontaktierung erfolgt vielmehr in dem erfindungsgemäßen flächigen Chipmodulträger, wodurch die Herstellungskosten einer kontaktlosen Chipkarte drastisch reduziert werden können.

In einer Ausgestaltung der Erfindung sind die ersten und die zweiten Metallisierungen in einem Raster angeordnet und durch Trenngebiete voneinander beabstandet. Die rasterförmige Anordnung der Metallisierungen ermöglicht das schnelle Arbeiten eines SMD-Bestückungsautomaten, der nach dem Collect-and-Place-Verfahren Halbleiterchips auf jeweilige erste Metallisierungen aufbringen kann. Die einfache geometrische Anordnung der Metallisierungen, vorteilhafterweise in einem orthogonalen Raster, ermöglicht dann ein besonders schnelles Bearbeiten.

Vorteilhafterweise weist der flächige Träger eine Größe von 368 x 460 mm auf. Diese Größe entspricht den derzeit gängigen Abmaßen, die mit Standard-SMD-Bestückungsautomaten verarbeitet werden können. Auf einem derart ausgebildeten flächigen Träger können, je nach Gestaltung, ca. 700 ISO-Standard-Chipmodule, von denen jedes acht Kontaktflächen aufweist, vorgesehen werden. Alternativ wäre auch denkbar, statt dieses Formates Endlosbögen oder andere Formate zu verwenden.

Die rasterförmige Anordnung der Metallisierungen, die der Fläche eines Chipmodules entsprechen, ermöglicht eine besonders einfache und kostengünstige sowie umweltfreundliche Herstellung. Bei der Metallisierung wird der flächige Träger ganzflächig mit Kupfer überzogen. Anschließend wird diese Schicht photomaskiert und geätzt. Da bei der flächigen Anordnung der Metallisierungen nur wenig nicht-metallisierte Flächen verbleiben, muß nur wenig Kupfer abgeätzt und ins Abwasser gespült werden. Nach der Kupfermetallisierung, kann dann eine Veredelung in gewohnter Art und Weise erfolgen.

Das erfindungsgemäße Herstellungsverfahren wird mit den Merkmalen des Patentanspruches 9 beschrieben. Das erfindungsgemäße Herstellungsverfahren umfaßt dabei folgende Schritte:
a) Bereitstellen eines flächigen Trägers, der beidseitig eine gleiche Anzahl an ersten und zweiten Metallisierungen aufweist, wobei der flächige Träger laterale Ausnehmungen aufweist, so daß dieser von einem Standard-SMD-Bestückungsautomaten bearbeitbar ist.
b) Bereitstellen einer der Anzahl der Metallisierungen entsprechenden Anzahl an Halbleiterchips mit Kontaktflächen.
c) Aufbringen der Halbleiterchips auf den flächigen Träger.
d) Herstellen einer elektrischen Verbindung zwischen dem Halbleiterchip und der Metallisierung.
e) Vereinzeln der durch eine erste und eine zweite Metallisierung, einen Ausschnitt aus dem flächigen Träger und den Halbleiterchip gebildeten Chipmodule.

Das Herstellungsverfahren für ein Chipmodul, das als Ausgangsprodukt einen flächigen Träger mit einer Vielzahl an entsprechenden Metallisierungen aufweist, die später jeweils Teil eines Chipmodules sind, ist deshalb besonders einfach, da aus der Spulenfertigung für eine kontaktlose Chipkarte die Verwendung von Kunststoff-Bögen mit aufgeätzter Spule bekannt sind. Auf diesen Kunststoff-Bögen wird der Antennenträger als Inlay herausgestanzt. Der Kunststoff-Bogen wird anschließend vollflächig mit Kupfer auflaminiert und anschließend strukturiert. Das aus der Antennenfertigung bekannte Herstellungsverfahren kann unverändert für die Herstellung des zweiseitig metallisierten Trägers verwendet werden. Dadurch, daß die "Packungsdichte" der Metallisierungen auf dem flächigen Träger jedoch sehr hoch ist, so daß nur wenig nicht nutzbare Flächen verbleiben, ist eine große Ersparnis bezüglich der Herstellungskosten möglich.

In einem weiteren Verfahrensschritt werden die Halbleiterchips durch einen SMD-Bestückungsautomaten auf dem flächigen Träger aufgebracht. Da SMD-Bestückungsautomaten gegenüber einem Herstellungsverfahren nach dem Reel-to-Reel-Verfahren wesentlich schneller arbeiten, können in der gleichen Zeit wesentlich mehr Chipmodule gefertigt werden.

Die Kontaktflächen des Halbleiterchips werden vorteilhafterweise bereits im Waferverbund mit einer Nickel-Gold-Legierung chemisch behandelt.

In einem weiteren Verfahrensschritt wird das Vereinzeln der Chipmodule durch Schneiden oder Stanzen vorgenommen.

Die Erfindung und weitere Vorteile werden anhand der nachfolgenden Figuren näher erläutert. Es zeigen:
- Figur 1: eine Draufsicht auf die zweite Hauptseite des flächigen Trägers,
- Figur 2: eine Draufsicht auf eine zweite Metallisierung,
- Figur 3: eine Draufsicht auf eine erste Metallisierung,
- Figur 4: ein Chipmodul im Querschnitt mit einem nach der Erfindung ausgestalteten Träger,
- Figur 5: eine Draufsicht auf die zweite Hauptseite eines erfindungsgemäßen Trägers, der zur Verbindung mit einer Spule vorgesehen ist,
- Figur 6: einen Querschnitt auf eine Trägerlage mit einer Spule und einem erfindungsgemäß ausgebildeten Träger,
- Figur 7: ein aus dem Stand der Technik bekanntes Trägerband mit zwei nebeneinander aufgebrachten Metallisierungen und
- Figur 8: ein aus dem Stand der Technik bekanntes Chipmodul im Querschnitt.

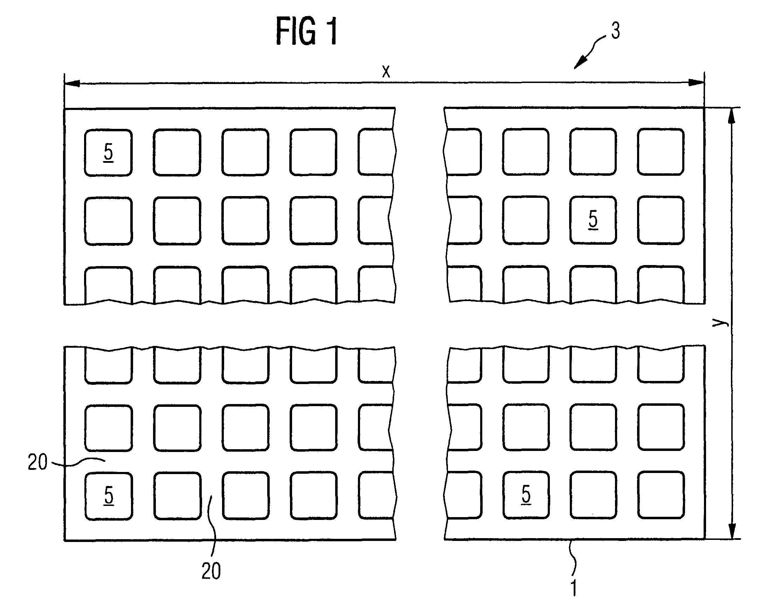

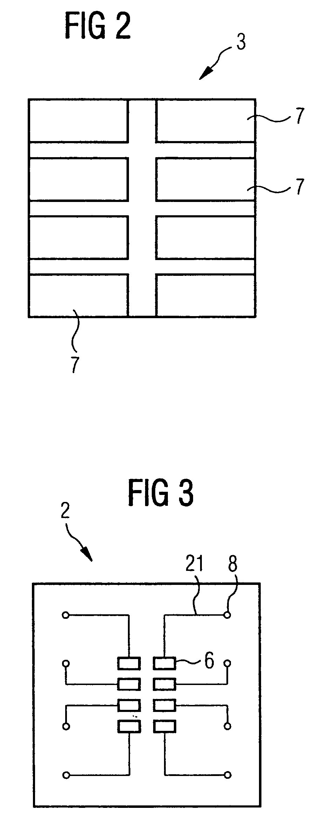

Figur 1 zeigt den erfindungsgemäßen flächigen Träger in einer Draufsicht auf die zweite Hauptseite. Die lateralen Abmaße des flächigen Trägers 1 sind mit x und y bezeichnet. Die lateralen Abmaße x,y können prinzipiell beliebig sein. Wesentlich dabei ist, daß die lateralen Abmaße dergestalt sind, daß der flächige Träger von einem SMD-Bestückungsautomat bearbeitet werden kann. Das derzeit gängige Format beträgt 368 x 460 mm für den flächigen Träger. Bei diesem Abmaß ist es möglich, ca. 700 zweite Metallisierungen 5 auf dem flächigen Träger vorzusehen. Soll das zu fertigende Chipmodul in einer kontaktbehafteten Chipkarte eingesetzt werden, so ist jede zweite Metallisierung 5 beispielsweise nach dem ISO-Standard ausgebildet. In diesem Fall weist jede zweite Metallisierung sechs oder acht Kontaktflächen auf. Auf der Rückseite ist jeder zweiten Metallisierung 5 eine erste Metallisierung 4 (vergleiche Figur 3) zugeordnet. Jede erste und jede zweite Metallisierung ist über Durchkontaktierungen elektrisch miteinander verbunden. Die erste Metallisierung ist derart ausgestaltet, daß die Kontaktflächen mit den Kontaktflächen eines Halbleiterchips direkt, d.h. ohne Bonddrähte, miteinander verbunden werden können.

Die Figur 2 zeigt eine Draufsicht auf die zweite Hauptseite eines aus dem flächigen Träger vereinzelten Trägers. Die zweite Hauptseite 3 beinhaltet die zweite Metallisierung, die im vorliegenden Beispiel acht zweite Kontaktflächen 7 aufweist. Die acht Kontaktflächen 7 sind nach dem ISO-Standard angeordnet und elektrisch voneinander getrennt.

Die Figur 3 zeigt eine Draufsicht auf die erste Hauptseite, d.h. die Rückseite von Figur 2. Hierbei wird die Ausgestaltung der ersten Metallisierung 4 ersichtlich. Die erste Metallisierung 4 weist erste Kontaktflächen 6 auf, die mit Kontaktflächen eines Halbleiterchips verbunden werden. Über Leiterzüge 21 ist jede erste Kontaktfläche 6 mit einer Durchkontaktierung 8 verbunden, die einen elektrischen Kontakt zu einer zugeordneten zweiten Kontaktfläche 7 aus Figur 2 herstellt. Der Träger übernimmt somit für den Halbleiterchip eine Umverdrahtung. Die elektrische Verbindung der ersten und der zweiten Kontaktflächen 6,7 kann auf verschiedene Arten erfolgen. Entweder werden in den flächigen Träger 1 an den Stellen der Kontaktflächen Löcher gestanzt und beispielsweise mit Leitpaste ausgefüllt. Alternativ könnte die Durchkontaktierung auch nach der sog. "Blackhole"-Methode erfolgen. Hierbei wird Kohlenstoff in den ausgestanzten Löchern abgeschieden und anschließend Kupfer abgeschieden.

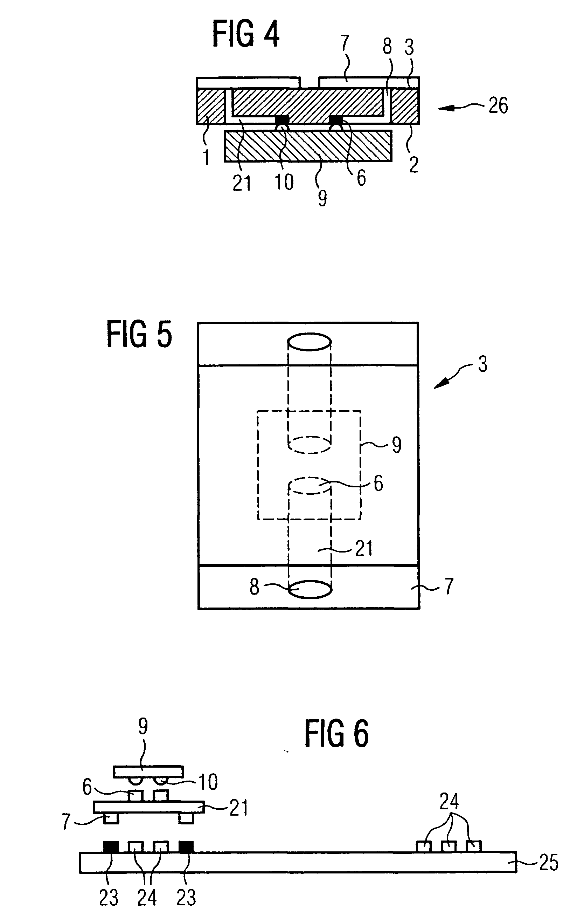

Die Figur 4 zeigt in einem Querschnitt ein Chipmodul 26, das auf einem erfindungsgemäßen flächigen Träger 1 hergestellt wurde. In der Figur wird die räumliche Anordnung der ersten und der zweiten Kontaktflächen 6,7 zueinander deutlich. Auf der zweite Hauptseite des flächigen Trägers 1, von dem in der Figur nur die Bereiche eines einzelnen Moduls dargestellt sind, weist auf der zweite Hauptseite die zweiten Kontaktflächen 7 auf. Diese sind über Durchkontaktierungen 8 und Leitzüge 21 mit den ersten Kontaktflächen 6 verbunden. Ein Halbleiterchip 9, der Kontaktflächen 10 aufweist, ist mit diesen mit den ersten Kontaktflächen 6 verbunden. Der zwischen der ersten Hauptseite 2 und dem Halbleiterchip gebildete Zwischenraum kann mit einem "Underfiller" ausgefüllt werden.

Figur 5 zeigt eine Draufsicht auf die zweite Hauptseite 3 eines Chipmoduls 26, bei dem Metallisierungen zur Kontaktierung mit einer Spule ausgestaltet sind. Auf der zweiten Hauptseite 3 sind zwei gegenüberliegende zweite Kontaktflächen 7 vorgesehen. Diese sind jeweils über Durchkontaktierungen 8 und Leiterbahnzüge 21 mit ersten Kontaktflächen 6 (strichliert dargestellt) verbunden. Die ersten Kontaktflächen 6 dienen dazu, einen elektrischen Kontakt zu einem Halbleiterchip 9 (strichliert dargestellt) herzustellen, der auf die erste Hauptseite 2 aufgebracht wird.

Die Anordnung der elektrischen Kontakte für eine Spule wird aus der nachfolgenden Figur 7 besser deutlich. Die Figur 7 zeigt einen Querschnitt durch eine Trägerlage 25, auf der eine Spule 22 aufgebracht ist. Die Spule 22 kann beispielsweise aufgeätzt oder vollflächig mit Kupfer laminiert und anschließend strukturiert oder mittels einer leitfähigen Paste und anschließender Bekeimung auf die Trägerlage 25 aufgebracht worden sein. In der vorliegenden Figur weist die Spule 22 drei Spulenwindungen 24 auf. Die Spulenanschlüsse 23 kommen in der vorliegenden Figur auf der linken Seite der Trägerlage 25 zum Liegen.

Im Stand der Technik war es bisher üblich, den Halbleiterchip direkt auf der Trägerlage 25 aufzubringen. Um einen Kurzschluß zu vermeiden, war es deshalb notwendig, einen der Spulenanschlüsse über eine Durchkontaktierung auf die der Spule gegenüber liegenden Seite der Trägerlage 25 zu führen und an einer anderen Stelle wiederum mittels einer Durchkontaktierung auf die Seite der Spule zu führen. Da eine derartige Durchkontaktierung jedoch teuer ist, ist es vorteilhafter, die Durchkontaktierung auf dem flächigen Träger der Chipmodule durchzuführen, da dort die Packungsdichte wesentlich höher ist und somit eine kostengünstigere Fertigung ermöglicht wird. Aus der Figur 6 wird nunmehr deutlich, daß die Umverdrahtung zu den Kontaktflächen 10 des Halbleiterchips 9 nicht in der Trägerlage 25, sondern mittels eines der erfindungsgemäßen Träger vorgenommen wird. Dieser weist auf der zweiten Hauptfläche zweite Kontaktflächen 7 auf, die mit den Spulenanschlüssen 23 verbunden werden. Über Durchkontaktierungen 8 und Leiterzüge 21 wird dann über erste Kontaktflächen 6 der elektrische Kontakt zu den Kontaktflächen 10 des Halbleiterchips 9 hergestellt.

Der flächige Träger 1 wird vorteilhafterweise aus einem thermoplastischen Kunststoff hergestellt. Es ist jedoch auch die Verwendung von Papier denkbar, auf dem die strukturierten Metallisierungen in Addetivtechnik oder Laminiertechnik aufgebracht werden. Die Gesamtdicke des Moduls ist abhängig von den eingesetzten Materialien. Ein aus einem thermoplastischen Kunststoff hergestellter flächiger Träger hat üblicherweise eine Dicke von 150 bis 200µm, wobei die Verbindungstechnik mit der Metallisierung bereits eingerechnet ist. Die Dicke eines Halbleiterchips beträgt üblicherweise zwischen 120 und 185µm. Somit sind bei der Verwendung von Standardmaterialen bereits Moduldicken von 270 bis 385µm realisierbar. Die Dicke der im Stand der Technik verwendeten Chipmodule, wie es in Figur 8 beschrieben ist, beträgt beim Vorsehen einer Vergußmasse um den Halbleiterchip ca. 500µm. Wird eine UV-Abdeckung vorgesehen, beträgt die Dicke ca. 580µm. Die Verwendung des erfindungsgemäßen flächigen Trägers ermöglicht neben außerordentlich hohen Kosteneinsparungen somit auch die Herstellung besonders dünner Chipmodule. Diese weisen den Vorteil auf, daß sie gegenüber mechanischen Biegebeanspruchungen, wie sie im täglichen Einsatz bei einer Chipkarte vorkommen, nicht so anfällig sind.

Da die Kosten bei der Herstellung eines Chipmoduls im wesentlichen von den Trägerbandkosten bestimmt sind (diese machen etwa 60 % der Materialkosten aus) ist die Verwendung eines gängigen thermoplastischen Kunststoffmaterials als flächiger Träger für die Chipmodule gegenüber einem aus Epoxydharz bestehenden Trägerband vorteilhaft, um eine starke Kostenreduzierung zu erzielen.

### Bezugszeichenliste

- 1: flächiger Träger
- 2: erste Hauptseite
- 3: zweite Hauptseite
- 4: erste Metallisierung
- 5: zweite Metallisierung
- 6: erste Kontaktflächen
- 7: zweite Kontaktflächen
- 8: Durchkontaktierung
- 9: Halbleiterchip
- 10: Kontaktfläche
- 11: Bonddraht
- 12: Träger
- 13: Metallisierung
- 14: Ausnehmung
- 15: Vergußmasse
- 16: Chipmodul
- 17: Trägerband
- 18: Führungsloch
- 19: Träger
- 20: Trenngebiete
- 21: Leiterzug
- 22: Spule
- 23: Spulenanschluß
- 24: Spulenwindung
- 25: Trägerlage
- 26: Chipmodul
- x, y: laterale Ausdehnung

## Patentansprüche

1. Flächiger Träger, insbesondere für ein Chipmodul (26) für den Einsatz in Chipkarten mit einer ersten und einer zweite Hauptseite (2,3), bei dem auf der ersten Hauptseite (2) eine Vielzahl an ersten Metallisierungen (4) und auf der zweiten Hauptseite (3) eine entsprechende Anzahl an zweiten Metallisierungen (5) vorgesehen ist, wobei die lateralen Ausdehnungen (x,y) des flächigen Trägers (1) derart bemessen sind, daß der flächige Träger von einem SMD-Bestückungsautomaten weiter verarbeitet werden kann.

2. Flächiger Träger nach Anspruch 1,
**dadurch gekennzeichnet**, daß
der flächige Träger aus einem thermoplastischen Kunststoff oder Papier besteht.

3. Flächiger Träger nach Anspruch 1 oder 2,
**dadurch gekennzeichnet**, daß
einander zugeordnete erste und zweite Metallisierungen (6,7) über Durchkontaktierungen (8) in dem flächigen Träger (1) miteinander elektrisch verbunden sind.

4. Flächiger Träger nach einem der Ansprüche 1 bis 3,
**dadurch gekennzeichnet**, daß
die ersten Metallisierungen (4) erste Kontaktflächen (6) aufweisen, die derart angeordnet sind, daß diese beim Aufbringen eines Halbleiterchips auf die erste Hauptseite (2) des flächigen Trägers (1) mit Kontaktflächen (10) des Halbleiterchips (9) aufeinander treffen.

5. Flächiger Träger nach einem der Ansprüche 1 bis 4
**dadurch gekennzeichnet**, daß
die zweiten Metallisierungen (5) zweite Kontaktflächen (7) aufweisen, die für eine externe Kontaktierung vorgesehen sind.

6. Flächiger Träger nach einem der Ansprüche 1 bis 5,
**dadurch gekennzeichnet**, daß
die zweite Metallisierung (5) zweite Kontaktflächen (7) aufweist, die zur Verbindung mit einer Spule (22) zur kontaktlosen Datenübertragung vorgesehen sind.

7. Flächiger Träger nach einem der Ansprüche 1 bis 6,
**dadurch gekennzeichnet**, daß
die ersten und die zweiten Metallisierungen (4,5) in einem Raster angeordnet sind und durch Trenngebiete voneinander beabstandet sind.

8. Flächiger Träger nach einem der Ansprüche 1 bis 7,
**dadurch gekennzeichnet**, daß
der flächige Träger (1) eine Größe von 368 x 460 mm aufweist.

9. Herstellungsverfahren für ein Chipmodul, insbesondere für eine Chipkarte, das folgende Schritte umfaßt:
a) Bereitstellen eines flächigen Trägers (1), der beidseitig eine gleiche Anzahl an ersten und zweiten Metallisierungen (4,5) aufweist, wobei der flächige Träger (1) laterale Ausdehnungen aufweist, so daß dieser von einem Standard-SMD-Bestückungsautomaten verarbeitbar ist.
b) Bereitstellen einer der Anzahl der Metallisierungen (4,5) entsprechenden Anzahl an Halbleiterchips (9) mit Kontaktflächen (10).
c) Aufbringen der Halbleiterchips (9) auf den flächigen Träger (1).
d) Herstellen einer elektrischen Verbindung zwischen dem Halbleiterchip und der Metallisierung.
e) Vereinzeln der durch eine erste und eine zweite Metallisierung (4,5), einen Ausschnitt aus dem flächigen Träger (1) und dem Halbleiterchip (9) gebildeten Chipmodule (16) .

10. Herstellungsverfahren für ein Chipmodul nach Anspruch 9,
**dadurch gekennzeichnet**, daß
die Halbleiterchips (9) durch einen SMD-Bestückungsautomaten auf den flächigen Träger (1) aufgebracht werden.

11. Herstellungsverfahren für ein Chipmodul nach Anspruch 9 oder 10,
**dadurch gekennzeichnet**, daß
die Kontaktflächen (10) des Halbleiterchips (9) bereits im Waferverbund mit einer Nickel-Gold-Legierung chemisch behandelt werden.

12. Herstellungsverfahren für ein Chipmodul nach einem der Ansprüche 9 bis 11,
**dadurch gekennzeichnet**, daß
das Vereinzeln der Chipmodule durch Schneiden oder Stanzen vorgenommen wird.
